# EUROPÄISCHE PATENTSCHRIFT

(11) **EP 4 217 530 B1**
(45) Veröffentlichungstag und Bekanntmachung des Hinweises auf die Patenterteilung: **30.10.2024**
(21) Anmeldenummer: 21794709.2
(22) Anmeldetag: 23.09.2021
(51) Int. Cl.: C30B 23/06, C30B 29/36, F27B 14/10, F27D 1/00

(54) **VORRICHTUNG ZUM ZÜCHTEN VON KRISTALLEN MIT EINER THERMISCHEN UMHÜLLUNGSEINHEIT**
APPARATUS FOR GROWING CRYSTALS, HAVING A THERMAL CASING UNIT
DISPOSITIF DE CROISSANCE DE CRISTAUX COMPORTANT UNE UNITÉ D'ENVELOPPEMENT THERMIQUE

(30) Priorität: 28.09.2020 AT 508182020
(43) Veröffentlichungstag der Anmeldung: 02.08.2023
(73) Patentinhaber: EBNER Industrieofenbau GmbH, 4060 Leonding (AT)
(72) Erfinder: ARIYAWONG, Kanaparin, 4060 Leonding (AT); BARBAR, Ghassan, 57290 Neunkirchen (DE); EBNER, Robert, 4060 Leonding (AT); HSIUNG, Chih-Yung, 4060 Leonding (AT)
(74) Vertreter: Burger, Hannes
(86) Internationale Anmeldenummer: PCT/AT2021/060340
(87) Internationale Veröffentlichungsnummer: WO 2022/061385

(56) Entgegenhaltungen:
- EP-A1- 3 260 582
- CN-A- 101 003 914
- CN-A- 111 074 339
- DE-C2- 3 448 179

## Beschreibung

Die Erfindung betrifft eine Vorrichtung zum Züchten von Kristallen mit einem Tiegel und einer diesen umgebenden Umhüllungseinheit zur thermischen Dämmung des Tiegels.

Die Kristallzucht ist ein Vorgang, wobei ein bestehender Kristall größer wird, da mehr Moleküle oder Ionen sich an ihrer Position im Kristallgitter anlagern. Ein Kristall definiert sich aus Atomen, Molekülen oder Ionen, die in einem geordneten, sich wiederholenden Muster angeordnet sind. Dies erfolgt zumeist in einem Kristallgitter, das sich in alle drei räumlichen Dimensionen erstreckt. Somit unterscheidet sich Kristallzucht vom Wachstum eines flüssigen Tropfens darin, dass während der Zucht die Moleküle oder Ionen in die korrekten Gitterpositionen fallen müssen, damit ein geordneter Kristall wachsen kann.

Ein Einkristall oder ein monokristalliner Feststoff ist ein Material, in welchem ein Kristallgitter der gesamten Probe kontinuierlich und ununterbrochen bis zu den Rändern der Probe ohne Korngrenzen vorliegt.

Es beschreibt die DE 10 2018 129 492 A1 der gleichen Anmelderin eine Vorrichtung und ein Verfahren zur Kristallzucht, insbesondere von Einkristallen. Dazu umfasst die Vorrichtung eine Kammer mit einem Aufnahmeraum, einen Tiegel und ein den Tiegel umgebendes Isoliermaterial, so dass das innere Volumen des Tiegels thermisch von der Umgebung isoliert ist. Eine Heizvorrichtung ist dazu vorgesehen, das innere Volumen des Tiegels aufzuheizen. Als Heizelemente der Heizvorrichtung werden RF (Radiofrequenz) Heizvorrichtungen, resistiven Heizvorrichtungen und Heizgeneratoren vorgeschlagen. Das Isoliermaterial füllt den Zwischenraum zwischen dem Tiegel und der inneren Kammerwandfläche der Kammerwand aus. Nachteilig dabei ist das Hantieren mit dem Isoliermaterial bei der Entnahme der im Tiegel hergestellten Kristalle.

Die EP 3 260 582 A4 beschreibt ebenfalls eine Vorrichtung für die Herstellung von Kristallen in einem Tiegel, der von einer aus einem Graphit-Filz gebildeten Isolierschicht umgeben ist. Der Tiegel samt dem Isoliermaterial ist in ein Doppelquarzrohr eingesetzt und lagert auf einem Graphittragstab auf. Der Innenraum des Doppelquarzrohrs ist weiters auf einen gegenüber dem Atmosphärendruck dazu geringeren Druck abgesenkt. Mittels einer um das Doppelquarzrohr herum angeordneten Heizvorrichtung wird der Tiegel und dessen Innenraum Tiegels für die Herstellung der Kristalle erhitzt. Es ist auch hier das Hantieren mit dem Isoliermaterial bei der Entnahme der im Tiegel hergestellten Kristalle schwierig durchzuführen.

Aufgabe der vorliegenden Erfindung war es, die Nachteile des Standes der Technik zu überwinden und eine Vorrichtung zur Herstellung von Kristallen zur Verfügung zu stellen, mittels derer ein Benutzer in der Lage ist, eine einfache Anbringung des Isoliermaterials vornehmen zu können und dabei eine sichere Halterung während des Herstellungsprozesses zu erzielen.

Diese Aufgabe wird durch eine Vorrichtung gemäß den Ansprüchen gelöst.

Die erfindungsgemäße Vorrichtung dient zum Züchten von Kristallen und umfasst
- einen Tiegel, welcher Tiegel eine äußere Mantelfläche definiert und weiters einen Aufnahmeraum mit einer Axialerstreckung zwischen einem Bodenabschnitt und einem Öffnungsabschnitt umgrenzt, wobei der Aufnahmeraum zum Züchten der Kristalle ausgebildet ist,
- eine Umhüllungseinheit, welche Umhüllungseinheit die äußere Mantelfläche zumindest abschnittsweise abdeckt und zur thermischen Dämmung des Tiegels ausgebildet ist, wobei weiters noch vorgesehen ist
- dass eine Halteeinheit vorgesehen ist, mittels welcher Halteeinheit die Umhüllungseinheit in ihrer Position relativ bezüglich des Tiegels am Tiegel gehalten ist,
- dass die Halteeinheit zumindest ein länglich ausgebildetes, bevorzugt biegeschlaffes, Halteelement mit einem ersten Endabschnitt und einem in seiner Längserstreckung davon beabstandeten zweiten Endabschnitt umfasst,
- dass das zumindest eine Halteelement die Umhüllungseinheit an der vom Tiegel abgewendeten Seite umfänglich umgibt und an der Umhüllungseinheit anliegend daran angeordnet ist, und
- dass der erste Endabschnitt und der zweite Endabschnitt bedarfsweise lösbar miteinander gekoppelt sind und vom zumindest einen Halteelement eine in radialer Richtung auf die Umhüllungseinheit wirkende Haltekraft aufgebracht ist.

Der dadurch erzielte Vorteil liegt darin, dass so eine rasche und variable Befestigungsmöglichkeit der Umhüllungseinheit an der Außenseite des Tiegels geschaffen wird. Damit wird auch nach dem Befüllen des Tiegels mit dem Basismaterial zur Züchtung und Bildung des Kristalls das Anbringen und auch das Befestigen sehr einfach und variabel durchführbar. Durch das Vorsehen der Halteeinheit, von welcher eine in radialer Richtung auf den Tiegel wirkenden Haltekraft auf die Umhüllungseinheit aufgebracht wird, erfolgt eine überwiegend auf Reibung basierende relative ortsfeste Halterung und Anbringung der isolierenden Umhüllungseinheit. Da das zumindest eine Halteelement länglich ausgebildet ist, erfolgt ein zumindest einmaliges außenseitiges Umschlingen der Umhüllungseinheit, wobei die beiden Endabschnitte des jeweiligen Halteelements miteinander verbunden oder aneinander gekuppelt werden. Damit wird eine feste und straffe Umschlingung geschaffen, mittels welcher einerseits die Halterung erzielt wird und andererseits bedingt durch die auf einfache Weise bedarfsweise lösbare Kopplungsverbindung eine Wegnahme oder ein Tausch einfach realisierbar ist.

Weiters kann es vorteilhaft sein, wenn das zumindest eine Halteelement aus einem Graphitwerkstoff gebildet ist. Damit wird eine hohe Temperaturbelastung und Temperatureinwirkung ermöglicht.

Eine andere Ausführungsform zeichnet sich dadurch aus, dass der erste Endabschnitt und der zweite Endabschnitt des zumindest einen Halteelements miteinander verknotet sind. Damit kann auf zusätzliche Bauelemente zur gegenseitigen Kopplung und Verbindung der Endabschnitte verzichtet werden.

Eine weitere mögliche Ausführungsform hat die Merkmale, dass eine Kopplungsvorrichtung für das zumindest eine Halteelement vorgesehen ist, mittels welcher Kopplungsvorrichtung der erste Endabschnitt und der zweite Endabschnitt des zumindest einen Halteelements miteinander gekoppelt sind. Durch das Vorsehen einer eigenen Kopplungsvorrichtung kann so eine noch sicherere gegenseitige Verbindung zwischen den beiden Endabschnitten des Halteelements geschaffen werden. Weiters kann die Kopplungsvorrichtung auch noch direkt an der Außenfläche der Umhüllungseinheit ortsfest gehalten oder befestigt sein und damit auch zur positionierten Halterung des Halteelements an der Umhüllungseinheit dienen.

Vorteilhaft ist es, wenn das länglich ausgebildete, bevorzugt biegeschlaffe, Halteelement aus der Gruppe von Schnur, Seil, Band, Gurt, Kette ausgewählt ist. Damit kann das für den jeweiligen Bedarfsfall bzw. Anwendungsfall geeignetste Halteelement ausgewählt werden. Es ist bei einer Mehrfachanordnung von Halteelementen auch eine Kombination von zueinander unterschiedlichen Halteelementen möglich.

Eine weitere Ausbildung sieht vor, dass mehrere Halteelemente vorgesehen sind und die Halteelemente in Richtung der Axialerstreckung des Tiegels voneinander beabstandet angeordnet sind. Damit kann in Richtung der Axialerstreckung des Tiegels gesehen eine durchgängigere Anlage der Umhüllungseinheit am Tiegel erzielt werden.

Eine andere Ausführungsform zeichnet sich dadurch aus, dass die Halteeinheit zumindest ein Führungselement umfasst, welches zumindest eine Führungselement an der Umhüllungseinheit an der vom Tiegel abgewendeten Seite angeordnet ist und das zumindest eine Führungselement dazu ausgebildet ist, das zumindest eine Halteelement in einer vorbestimmten relativen Position bezüglich der Umhüllungseinheit zu führen. Damit kann eine Vorpositionierung und auch eine unbeabsichtigte Verlagerung des Halteelements in einem größeren Ausmaß, insbesondere bei lotrechter Anordnung des Tiegels, verhindert werden. Weiters kann das Halteelement auch bei einer Abnahme der Umhüllungseinheit vom Tiegel an der Halteeinheit verbleiben und braucht bei einem neuerlichen Anbringen in der Isolierstellung nicht gesondert gehandhabt werden.

Eine weitere bevorzugte Ausführungsform ist dadurch gekennzeichnet, dass die Umhüllungseinheit in Umfangsrichtung gesehen einen ersten Längsrandabschnitt und einen zweiten Längsrandabschnitt aufweist und die einander zugewendeten Längsrandabschnitte in Umfangsrichtung einander überlappend angeordnet sind. Durch das einander gegenseitige Überlappen kann so auf eine exakte umfängliche Längsanpassung der Umhüllungseinheit verzichtet werden. Darüber hinaus kann so eine umfänglich gesehen durchgängige Abdeckung und damit verbunden eine gute thermische Isolierwirkung erzielt werden.

Weiters kann es vorteilhaft sein, wenn die Umhüllungseinheit den Tiegel in Richtung seiner Axialerstreckung an zumindest einer Seite auf die vom Tiegel abgewendete Seite überragt. Damit kann insbesondere im Deckelbereich mit einem zusätzlichen Isolierelement eine hohe Isolierwirkung erzielt werden. Weiters kann damit auch eine gute und ausreichende Haltewirkung für das zusätzliche Isolierelement, insbesondere in radialer Richtung, erzielt werden.

Eine andere alternative Ausführungsform zeichnet sich dadurch aus, dass die Umhüllungseinheit aus einem Graphit-Filz gebildet ist. Damit wird ein hoch-temperaturbeständiger Werkstoff eingesetzt, um auch über einen längeren Zeitraum eine gute thermische Isolierwirkung erzielen zu können.

Eine weitere mögliche und gegebenenfalls alternative Ausführungsform hat die Merkmale, dass der Graphit-Filz zumindest eine Lage aus einem Graphit-Hartfilz umfasst. Damit kann in gewissen Grenzen bereits ein vorgeformter Isolierkörper ausgebildet werden.

Eine weitere Ausbildung sieht vor, dass der Graphit-Filz zumindest eine Lage aus einem Graphit-Weichfilz umfasst. Damit kann eine bessere und flächenmäßig durchgängigere Anlage am Tiegel erzielt werden.

Eine andere Ausführungsform zeichnet sich dadurch aus, dass die zumindest eine Lage aus einem Graphit-Hartfilz dem Tiegel näherliegend angeordnet ist als die zumindest eine Lage aus dem Graphit-Weichfilz.

So kann eine noch bessere und sattere Anlage und Abdeckung am Tiegel erzielt werden.

Eine weitere bevorzugte Ausführungsform ist dadurch gekennzeichnet, dass der Tiegel aus einem Material gebildet ist, welches aus einer Gruppe, welche Metall-basierten, Oxid-basierten, Nitrid-basierten, Karbon-basierten und dichten Graphit aufweist, ausgewählt ist.

Weiters kann es vorteilhaft sein, wenn der Tiegel mehrteilig ausgebildet ist und einen Tiegel-Bodenteil, zumindest einen Tiegel-Wandteil und einen Tiegel-Deckelteil umfasst. Damit kann eine einfachere Ausformung der Tiegelteile realisiert werden. Weiters kann damit aber auch eine Art von Baukastensystem ausgebildet werden, um so für jeden Prozessablauf die dazu erforderlichen Tiegelabmessungen anpassen zu können.

Eine andere Ausführungsform zeichnet sich dadurch aus, dass eine Positionieranordnung vorgesehen ist, mittels welcher Positionieranordnung zumindest der Tiegel-Bodenteil und der zumindest eine Tiegel-Wandteil an den einander zugewendeten Enden in einer vorbestimmten relativen Position zueinander ausgerichtet positioniert sind. Damit kann eine gegenseitige Ausrichtung und Positionierungen der Einzelkomponenten in deren zusammengesetzten Zustand erreicht werden.

Eine weitere mögliche Ausführungsform hat die Merkmale, dass ein Gehäuse vorgesehen ist, welches Gehäuse eine Aufnahmekammer definiert und der Tiegel samt der Umhüllungseinheit und der Halteeinheit in der Aufnahmekammer aufgenommen ist. Damit wird eine zusätzliche Umhüllung zur Bereitstellung von für den jeweiligen Prozessablauf erforderlichen Umgebungsbedingungen um den Tiegel herum geschaffen.

Eine weitere Ausbildung sieht vor, dass eine Heizvorrichtung vorgesehen ist, welche Heizvorrichtung bevorzugt umfänglich um das Gehäuse herum angeordnet ist und dazu ausgebildet ist, um für den Tiegel Wärmeenergie bereitzustellen. Damit wird im Betrieb die Wärmezufuhr zum Tiegel und dem zur Bildung des Kristalls im Tiegel befindlichen Basismaterial ermöglicht.

Zum besseren Verständnis der Erfindung wird diese anhand der nachfolgenden Figuren näher erläutert.

Es zeigen jeweils in stark vereinfachter, schematischer Darstellung:
- Fig. 1: ein Ausführungsbeispiel einer Vorrichtung zur Kristallbildung mit einem Tiegel, an dessen Außenseite eine Umhüllungseinheit mittels einer Halteeinheit daran positioniert gehalten ist, im Axialschnitt;
- Fig. 2: den Tiegel nach Fig. 1 samt dessen Umhüllungseinheit und Halteeinheit alleinig, im Querschnitt gemäß den Linien II-II in Fig. 1;
- Fig. 3: eine weitere mögliche Ausführungsform eines Tiegels, im Axialschnitt.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

Der Begriff "insbesondere" wird nachfolgend so verstanden, dass es sich dabei um eine mögliche speziellere Ausbildung oder nähere Spezifizierung eines Gegenstands oder eines Verfahrensschritts handeln kann, aber nicht unbedingt eine zwingende, bevorzugte Ausführungsform desselben oder eine zwingende Vorgehensweise darstellen muss.

In ihrer vorliegenden Verwendung sollen die Begriffe "umfassend", "weist auf", "aufweisend", "schließt ein", "einschließlich", "enthält", "enthaltend" und jegliche Variationen dieser eine nicht ausschließliche Einbeziehung abdecken.

Als weiterer Begriff wird auch noch "wahlweise" verwendet. Darunter wird verstanden, dass dieser Verfahrensschritt oder diese Anlagenkomponente grundsätzlich vorhanden ist, jedoch je nach Einsatzbedingungen eingesetzt werden kann, dies jedoch nicht zwingend erfolgen muss.

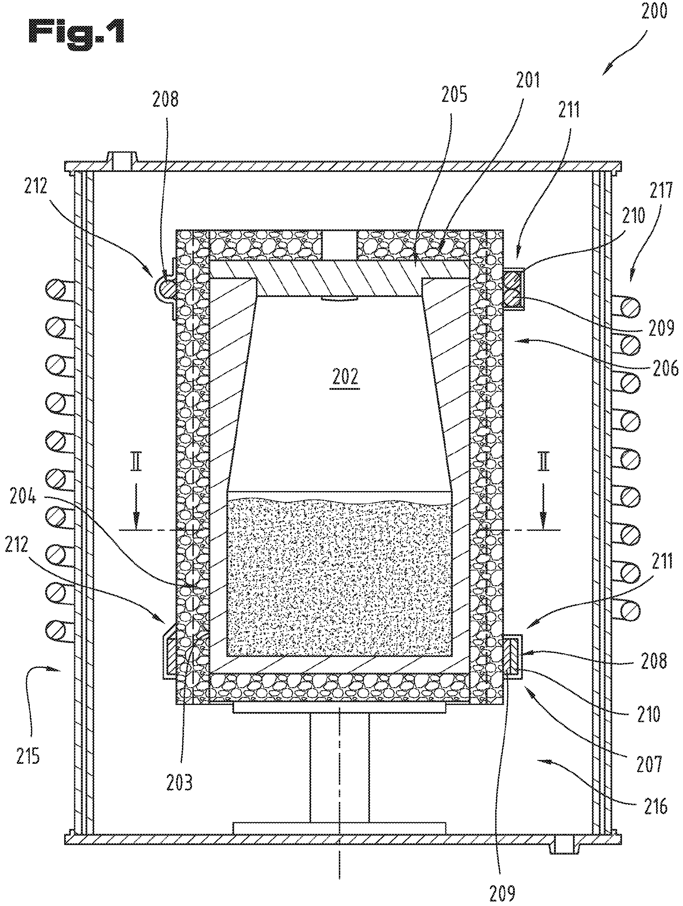

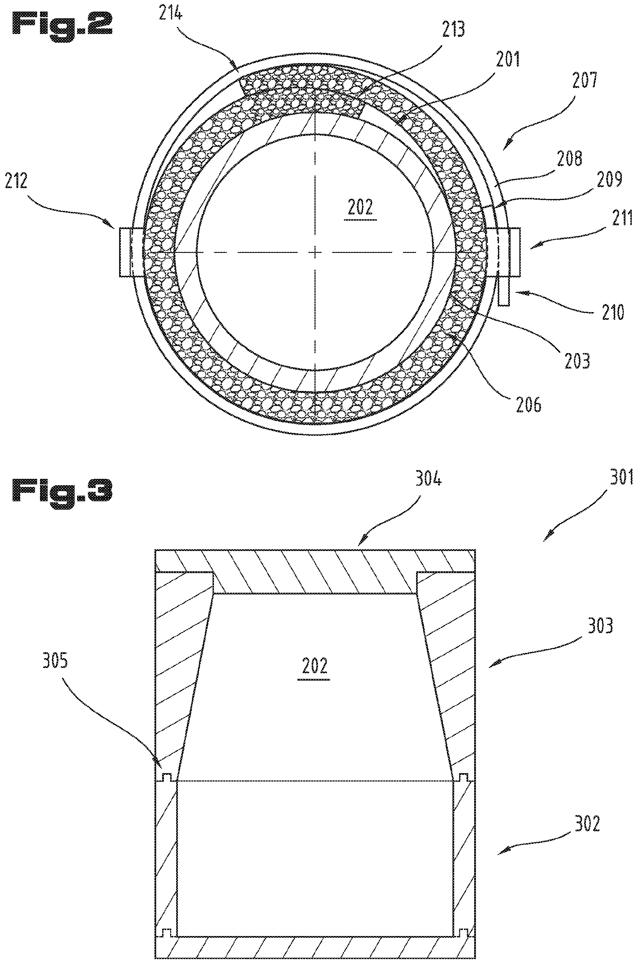

In den Fig. 1 und 2 ist ein mögliches Ausführungsbeispiel einer Vorrichtung 200 in unterschiedlichen Ansichten gezeigt, welche Vorrichtung 200 zur Züchtung von Kristallen dient oder dazu ausgebildet ist.

Dazu ist unter anderem ein Tiegel 201 vorgesehen, der in seinem Inneren in bekannter Weise einen Aufnahmeraum 202 umgrenzt. Zumeist weist der Tiegel 201 einen hohlzylinderförmigen Querschnitt auf, wobei auch davon abweichende Querschnittsformen, wie z.B. mehreckig, oval oder dergleichen, möglich sind. Der Tiegel 201 definiert weiters eine äußere Mantelfläche 203. Der Aufnahmeraum 202 weist in Richtung seiner Höhe eine Axialerstreckung auf, welche sich zwischen einem Bodenabschnitt 204 und einem Öffnungsabschnitt 205 erstreckt. Der Tiegel 201 mit seinem Aufnahmeraum 202 ist zum Züchten der Kristalle ausgebildet.

Zur thermischen Dämmung und Isolierung des Tiegels 201 ist weiters eine Umhüllungseinheit 206 vorgesehen, welche die äußere Mantelfläche 203 des Tiegels 201 zumindest abschnittsweise abdeckt, bevorzugt jedoch vollständig abdeckt. Die Umhüllungseinheit 206 umgibt den Tiegel 201 bei diesem Ausführungsbeispiel in Umfangsrichtung vollständig, um so eine durchgängige und unterbrechungslose thermische Dämmung zu erzielen.

Im vorliegenden Ausführungsbeispiel ist die Umhüllungseinheit 206 aus einem Graphit-Filz gebildet. Der Werkstoff Graphit ist für die zumeist hohen Temperaturen gut geeignet und hält diesen im laufenden Produktionsprozess ausreichend stand. Der Graphit-Filz weist eine sehr niedrige Wärmeleitfähigkeit auf und ist aus miteinander vernadelten Fasern und/oder miteinander verbundenen Fasergemischen gebildet, zwischen welchen ein mehr oder weniger großer Luftpolster ausgebildet ist. Bei Graphit-Filz unterscheidet man sogenannten Graphit-Weichfilz und Graphit-Hartfilz. Der Graphit-Hartfilz wird zumeist durch Mischen und Pressen von Fasergemischen und Bindemitteln, wie Phenolharzen, und anschließender Hochtemperaturbehandlung gebildet. Diese Filze werden zumeist mittels einer mechanischen Bearbeitung auf die gewünschten Abmessungen gebracht. Eine Umformung in einem größeren Ausmaß ist meist nicht mehr möglich, wobei die Formgebung bevorzugt vor dem Aushärten des Bindemittels erfolgt.

Der Graphit-Weichfilz wird aus miteinander vernadelten Fasern, zumeist Zellulosefasern oder dergleichen, gebildet und einer nachfolgenden thermischen Behandlung unterzogen. Derartige Filze sind in ihrer Formgebung einfach anzupassen, wie z.B. durch Schneiden mit einem Messer oder einer Schere.

Die Umhüllungseinheit 206 kann je nach Bedarf zumindest eine Lage aus dem Graphit-Hartfilz umfassen. Es wäre aber auch möglich, dass die Umhüllungseinheit 206 zumindest eine Lage aus dem Graphit-Weichfilz umfasst. Unabhängig davon kann die Umhüllungseinheit 206 aber auch aus zumindest einer Lage aus dem Graphit-Hartfilz und aus zumindest einer Lage aus dem Graphit-Weichfilz gebildet sein. Dies ist in der Fig. 1 in strichlierten Linien angedeutet. Bei einer mehrlagigen Ausbildung der Umhüllungseinheit 206 kann z.B. die zumindest eine Lage aus einem Graphit-Hartfilz dem Tiegel 201 näherliegend angeordnet sein als die zumindest eine Lage aus dem Graphit-Weichfilz. Es wäre aber auch noch möglich, dass die zumindest eine Lage aus dem Graphit-Hartfilz dem Tiegel 201 näherliegend angeordnet ist als die zumindest eine Lage aus einem Graphit-Weichfilz.

Bei den Fasern des Filzes kann es sich um Kurzfasern und/oder Langfasern handeln. Die Kurzfasern weisen zumeist eine gestreckte Faserlänge ausgewählt aus einem Wertebereich mit einer unteren Grenze von 0,1 mm bis hin zu einer oberen Grenze von 5 mm auf. Handelt es sich um sogenannte Langfasern, weisen diese eine gestreckte Faserlänge ausgewählt aus einem Wertebereich mit einer unteren Grenze von größer 5 mm und einer oberen Grenze von 15 mm, insbesondere von 10 mm, auf.

Der Tiegel 201 ist seinerseits ebenfalls aus einem temperaturfesten oder hochtemperaturfesten Werkstoff gebildet. Dabei kann das Material oder der Werkstoff des Tiegels 201 aus einer Gruppe, welche Metall-basierten, Oxid-basierten, Nitrid-basierten, Karbon-basierten und dichten Graphit aufweist, ausgewählt sein. Dabei kann es sich z.B. die Werkstoffe Silicium (Si), Siliziumcarbid (SiC), Aluminiumoxid (Al₂O₃), Galliumnitrid (GaN) oder Aluminiumnitrid (AlN) handeln. Es können auch Keramik-Werkstoffe eingesetzt werden.

Zur positionierten Halterung der Umhüllungseinheit 206 direkt am zumeist freistehenden Tiegel 201 ist hier eine eigene Halteeinheit 207 vorgesehen. Da zumeist oder bevorzugt der Tiegel 201 eine zylinderförmige oder zylinderähnliche Außenfläche aufweist, welche die äußere Mantelfläche 203 definiert, kann die Umhüllungseinheit 206 nach dem Befüllen des Aufnahmeraums 202 mit dem zur Bildung der Kristalle bestimmten Basismaterials einfach angeordnet und befestigt werden oder bedarfsweise nach dem Herstellen der Kristalle für deren Entnahme aus dem Tiegel 201 wieder in einem einfachen Arbeitsschritt von einer Bedienperson vom Tiegel 201 nach dem Lösen der Halteeinheit 207 abgenommen werden.

Dazu umfasst die Halteeinheit 207 zumindest ein Halteelement 208, welches zumindest einmal außenseitig um die Umhüllungseinheit 206 herum geschlungen ist und somit die Umhüllungseinheit 206 umfänglich umgibt. Das Halteelement 208 kann auch als Haltemittel oder Spannmittel bezeichnet werden. Dazu weist das Halteelement 208 eine Längserstreckung auf, welche wesentlich größer ist als dessen Querschnittsabmessung. Somit ist das Halteelement 208 länglich ausgebildet und überwiegend oder bevorzugt biegeschlaff. Je nach dem verwendeten Werkstoff zur Bildung des Halteelements 208 kann dieses auch eine gewisse Eigensteifigkeit aufweisen.

Weiters ist das zumindest eine Halteelement 208 derart angeordnet, dass dieses an der Umhüllungseinheit 206 außenseitig daran anliegend angeordnet ist. Das Halteelement 208 weist einen ersten Endabschnitt 209 und einen in seiner Längserstreckung davon beabstandeten zweiten Endabschnitt 210 auf. Zur gegenseitigen Verbindung des länglich ausgebildeten Halteelements 208 ist weiters vorgesehen, dass der erste Endabschnitt 209 und der zweite Endabschnitt 210 miteinander gekoppelt sind. Wird eine umfängliche Vorspannkraft auf das zumindest eine Halteelement 208 vor dem Verbringen in seine gekoppelte Stellung der beiden Endabschnitte 209, 210 aufgebracht, erfolgt ein umfängliches Anliegen an der Halteeinheit 207. So wird eine in radialer Richtung auf die Umhüllungseinheit 206 wirkende Haltekraft aufgebracht diese und an die Mantelfläche 203 des Tiegels 201 angedrückt.

Der erste Endabschnitt 209 und der zweite Endabschnitt 210 des zumindest einen Halteelements 208 kann zu deren Kopplungsverbindung miteinander verknotet sein.

Es könnte zur Bildung der Kopplungsverbindung der beiden Endabschnitte 209, 210 des Halteelements 208 auch eine eigene Kopplungsvorrichtung 211 vorgesehen sein. Diese ist schematisch vereinfacht dargestellt. Die Kopplungsvorrichtung 211 kann z.B. ähnlich aufgebaut sein, wie diese bei Spanngurten hinlänglich bekannt ist. Es könnten aber auch Schnallenverbindungen oder andere Klemmvorrichtungen eingesetzt werden.

Das zumindest eine Halteelement 208 soll ebenfalls aus einem temperaturbeständigen oder einem hochtemperaturbeständigen Werkstoff, wie z.B. aus einem Graphitwerkstoff, gebildet sein. Das Halteelement 208 soll weiters eine ausreichende Zugfestigkeit sowie einfache Querverformbarkeit aufweisen. Das länglich ausgebildete, bevorzugt biegeschlaffe, Halteelement 208 kann aus der Gruppe von Schnur, Seil, Band, Gurt, Kette ausgewählt sein. Die Ausbildung des Halteelements 208 als Band oder Gurt ist im Bereich des Bodenabschnitts 202 und die Ausbildung als Schnur oder Seil ist im Bereich des Öffnungsabschnitts 205 dargestellt.

Je nach Bauhöhe des Tiegels 201 und einer besseren vollständigen Umhüllung des Tiegels 201 können auch mehrere Halteelement 208 vorgesehen sein. Dabei kann eine in Richtung der Axialerstreckung des Tiegels 201 voneinander beabstandete Anordnung gewählt werden.

Um eine umfängliche Führung des zumindest einen Halteelements 208 an der Umhüllungseinheit 206 zu erzielen, kann die Halteeinheit 207 zumindest ein Führungselement 212 umfassen, wobei je Halteelement 208 aber auch mehrere der Führungselemente 212 über den Umfang verteilt angeordnet sein können. Dazu ist das Führungselement 212 oder sind die Führungselemente 212 an der vom Tiegel 201 abgewendeten Seite an der Umhüllungseinheit 206 angeordnet, insbesondere daran befestigt. Das zumindest eine Führungselement 212 ist dazu ausgebildet oder konfiguriert, das zumindest eine Halteelement 208 in einer vorbestimmten relativen Position bezüglich der Umhüllungseinheit 206 zu führen.

Die Umhüllungseinheit 206 kann plattenförmig ausgebildet sein, wobei je nach gewählter Ausbildung auch eine vorgeformte und an den Außenquerschnitt des Tiegels 201 angepasst Querschnittsform gewählt werden kann. Zumeist oder bevorzugt ist zumindest ein sich in überwiegend paralleler Ausrichtung bezüglich der Axialerstreckung erstreckender Trennabschnitt oder Überlappungsabschnitt vorgesehen.

Wie nun besser aus der Fig. 2 zu ersehen ist, weist die Umhüllungseinheit 206 bevorzugt in Umfangsrichtung gesehen einen ersten Längsrandabschnitt 213 und einen zweiten Längsrandabschnitt 214 auf. In der Isolierstellung der Umhüllungseinheit 206 am Tiegel 201 können die beiden Längsrandabschnitte 213, 214 in Umfangsrichtung einander überlappend angeordnet sein.

Weiters kann die Umhüllungseinheit 206 den Tiegel 201 in Richtung seiner Axialerstreckung an zumindest einer Seite auf die vom Tiegel 201 abgewendete Seite überragen und somit darüber hinaus vorragen.

Die Vorrichtung 200 kann weiters auch noch ein eigenes Gehäuse 215 umfassen, welches in seinem Innenraum eine Aufnahmekammer 216 definiert. Die Aufnahmekammer 216 ist bevorzugt gegenüber der äußeren Atmosphäre abgedichtet und kann auch noch auf einen dazu abgesenkten Innendruck evakuiert sein. Als Werkstoff für das Gehäuse 215 kann ein durchsichtiger Werkstoff Anwendung finden. Dabei kann es sich um einen Glaswerkstoff, insbesondere ein Quarzglas, handeln. Der Tiegel 201 ist samt der Umhüllungseinheit 206 und der in der Aufnahmekammer 216 aufgenommen.

Durch das Vorsehen der zusätzlichen Halteeinheit 207 ist es nicht mehr zwingend erforderliche, dass der Zwischenraum zwischen der Außenfläche bzw. der Mantelfläche 203 des Tiegels 201 und der Innenwandfläche des Gehäuses 215 vollständig von der isolierenden Umhüllungseinheit 206 ausgefüllt sein muss. Es ist eine beabstandete Anordnung möglich.

Zu Bereitstellung von Wärmeenergie zur Aufheizung des Tiegels 201, dessen Aufnahmeraum 202 und dem darin befindlichen Basismaterial zur Kristallbildung ist weiters eine Heizvorrichtung 217 vorgesehen. Die Heizvorrichtung 217 ist bevorzugt umfänglich um das Gehäuse 215 herum angeordnet und weiters dazu ausgebildet, um für den Tiegel 201 die erforderliche Wärmeenergie bereitzustellen.

Auf die Darstellung einer Steuerungsvorrichtung, einer Energieversorgungseinheit sowie von Verbindungs- und Versorgungsleitungen wurde der besseren Übersichtlichkeit halber verzichtet.

In der Fig. 3 ist ein mögliches Ausführungsbeispiel eines mehrteilig ausgebildet Tiegels gezeigt, weshalb für diese Ausbildung ein zu dem zuvor beschriebenen Tiegel 201 dazu unterschiedliches Bezugszeichen verwendet wird, nämlich das Bezugszeichen 301. Bei der gezeigten Darstellung handelt es sich um einen Axialschnitt bei aufrechter, stehender Position des Tiegels 301.

Es wird nachfolgend nur der Aufbau des Tiegels 301 beschrieben, wobei die zuvor beschriebenen Teile und Komponenten zur Bildung der Vorrichtung 200 auch in Verbindung mit diesem Tiegel 301 eingesetzt werden können. Deshalb wird, um unnötige Wiederholungen zu vermeiden, auf die detaillierte Beschreibung in den vorangegangenen Fig. 1 und 2 hingewiesen bzw. Bezug genommen.

Bei diesem gezeigten Ausführungsbeispiel umfasst der Tiegel 301 einen Tiegel-Bodenteil 302, zumindest einen Tiegel-Wandteil 302 und einen Tiegel-Deckelteil 304. Um die einzelnen den Tiegel 301 bildenden Bauteile zueinander positioniert ausrichten und anordnen zu können, ist bei diesem Ausführungsbeispiel zumindest eine Positionieranordnung 305 vorgesehen oder ausgebildet. Die Positionieranordnung 305 ist hier zwischen dem Tiegel-Bodenteil 302, nämlich einem vom Boden aufragenden Wandabschnitt, und dem zumindest einen Tiegel-Wandteil 303 angeordnet oder ausgebildet.

Die Positionieranordnung 305 kann unterschiedlichst ausgebildet sein, wobei an einander zugewendeten Enden des Tiegel-Bodenteils 302 und des Tiegel-Wandteils 303 jeweils zumindest ein Positionierelement vorgesehen ist. Die einander zugewendeten Positionierelemente sind zum gegenseitigen Zusammenwirken ausgebildet oder konfiguriert. Die Positionieranordnung 305 kann z.B. in Form oder Art einer Nut-Feder-Verbindung, vor- und rückspringenden Positionierelementen oder dergleichen ausgebildet sein.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 200: Vorrichtung
- 201: Tiegel
- 202: Aufnahmeraum
- 203: Mantelfläche
- 204: Bodenabschnitt
- 205: Öffnungsabschnitt
- 206: Umhüllungseinheit
- 207: Halteeinheit
- 208: Halteelement
- 209: erster Endabschnitt
- 210: zweiter Endabschnitt
- 211: Kopplungsvorrichtung
- 212: Führungselement
- 213: Längsrandabschnitt
- 214: Längsrandabschnitt
- 215: Gehäuse
- 216: Aufnahmekammer
- 217: Heizvorrichtung
- 301: Tiegel
- 302: Tiegel-Bodenteil
- 303: Tiegel-Wandteil
- 304: Tiegel-Deckelteil
- 305: Positionieranordnung

## Patentansprüche

1. Vorrichtung (200) zum Züchten von Kristallen, umfassend
- einen Tiegel (201, 301), welcher Tiegel (201, 301) eine äußere Mantelfläche (203) definiert und weiters einen Aufnahmeraum (202) mit einer Axialerstreckung zwischen einem Bodenabschnitt (204) und einem Öffnungsabschnitt (205) umgrenzt, wobei der Aufnahmeraum (202) zum Züchten der Kristalle ausgebildet ist,
- eine Umhüllungseinheit (206), welche Umhüllungseinheit (206) die äußere Mantelfläche (203) zumindest abschnittsweise abdeckt und zur thermischen Dämmung des Tiegels (201, 301) ausgebildet ist,
**dadurch gekennzeichnet,**
- **dass** eine Halteeinheit (207) vorgesehen ist, mittels welcher Halteeinheit (207) die Umhüllungseinheit (206) in ihrer Position relativ bezüglich des Tiegels (201, 301) am Tiegel (201, 301) gehalten ist,
- **dass** die Halteeinheit (207) zumindest ein länglich ausgebildetes, bevorzugt biegeschlaffes, Halteelement (208) mit einem ersten Endabschnitt (209) und einem in seiner Längserstreckung davon beabstandeten zweiten Endabschnitt (210) umfasst,
- **dass** das zumindest eine Halteelement (208) die Umhüllungseinheit (206) an der vom Tiegel (201, 301) abgewendeten Seite umfänglich umgibt und an der Umhüllungseinheit (206) anliegend daran angeordnet ist, und
- **dass** der erste Endabschnitt (209) und der zweite Endabschnitt (210) bedarfsweise lösbar miteinander gekoppelt sind und vom zumindest einen Halteelement (208) eine in radialer Richtung auf die Umhüllungseinheit (206) wirkende Haltekraft aufgebracht ist.

2. Vorrichtung (200) nach Anspruch 1, **dadurch gekennzeichnet, dass** das zumindest eine Halteelement (208) aus einem Graphitwerkstoff gebildet ist.

3. Vorrichtung (200) nach Anspruch 1 oder 2, **dadurch gekennzeichnet, dass** der erste Endabschnitt (209) und der zweite Endabschnitt (210) des zumindest einen Halteelements (208) miteinander verknotet sind.

4. Vorrichtung (200) nach Anspruch 1 oder 2, **dadurch gekennzeichnet, dass** eine Kopplungsvorrichtung (211) für das zumindest eine Halteelement (208) vorgesehen ist, mittels welcher Kopplungsvorrichtung (211) der erste Endabschnitt (209) und der zweite Endabschnitt (210) des zumindest einen Halteelements (208) miteinander gekoppelt sind.

5. Vorrichtung (200) nach einem der vorhergehenden Ansprüche, **dadurch gekennzeichnet, dass** das länglich ausgebildete, bevorzugt biegeschlaffe, Halteelement (208) aus der Gruppe von Schnur, Seil, Band, Gurt, Kette ausgewählt ist.

6. Vorrichtung (200) nach einem der vorhergehenden Ansprüche, **dadurch gekennzeichnet, dass** mehrere Halteelemente (208) vorgesehen sind und die Halteelemente (208) in Richtung der Axialerstreckung des Tiegels (201, 301) voneinander beabstandet angeordnet sind.

7. Vorrichtung (200) nach einem der vorhergehenden Ansprüche, **dadurch gekennzeichnet, dass** die Halteeinheit (207) zumindest ein Führungselement (212) umfasst, welches zumindest eine Führungselement (212) an der Umhüllungseinheit (206) an der vom Tiegel (201, 301) abgewendeten Seite angeordnet ist und das zumindest eine Führungselement (212) dazu ausgebildet ist, das zumindest eine Halteelement (208) in einer vorbestimmten relativen Position bezüglich der Umhüllungseinheit (206) zu führen.

8. Vorrichtung (200) nach einem der vorhergehenden Ansprüche, **dadurch gekennzeichnet, dass** die Umhüllungseinheit (206) in Umfangsrichtung gesehen einen ersten Längsrandabschnitt (213) und einen zweiten Längsrandabschnitt (214) aufweist und die einander zugewendeten Längsrandabschnitte (213, 214) in Umfangsrichtung einander überlappend angeordnet sind.

9. Vorrichtung (200) nach einem der vorhergehenden Ansprüche, **dadurch gekennzeichnet, dass** die Umhüllungseinheit (206) den Tiegel (201, 301) in Richtung seiner Axialerstreckung an zumindest einer Seite auf die vom Tiegel (201, 301) abgewendete Seite überragt.

10. Vorrichtung (200) nach einem der vorhergehenden Ansprüche, **dadurch gekennzeichnet, dass** die Umhüllungseinheit (206) aus einem Graphit-Filz gebildet ist.

11. Vorrichtung (200) nach Anspruch 10, **dadurch gekennzeichnet, dass** der Graphit-Filz zumindest eine Lage aus einem Graphit-Hartfilz umfasst.

12. Vorrichtung (200) nach Anspruch 10 oder 11, **dadurch gekennzeichnet, dass** der Graphit-Filz zumindest eine Lage aus einem Graphit-Weichfilz umfasst.

13. Vorrichtung (200) nach einem der Ansprüche 10 bis 12, **dadurch gekennzeichnet, dass** die zumindest eine Lage aus einem Graphit-Hartfilz dem Tiegel (201, 301) näherliegend angeordnet ist als die zumindest eine Lage aus dem Graphit-Weichfilz.

14. Vorrichtung (200) nach einem der vorhergehenden Ansprüche, **dadurch gekennzeichnet, dass** der Tiegel (201, 301) aus einem Material gebildet ist, welches aus einer Gruppe, welche Metall-basierten, Oxid-basierten, Nitrid-basierten, Karbon-basierten und dichten Graphit aufweist, ausgewählt ist.

15. Vorrichtung (200) nach einem der vorhergehenden Ansprüche, **dadurch gekennzeichnet, dass** der Tiegel (301) mehrteilig ausgebildet ist und einen Tiegel-Bodenteil (302), zumindest einen Tiegel-Wandteil (303) und einen Tiegel-Deckelteil (304) umfasst.

16. Vorrichtung (200) nach Anspruch 15, **dadurch gekennzeichnet, dass** eine Positionieranordnung (305) vorgesehen ist, mittels welcher Positionieranordnung (305) zumindest der Tiegel-Bodenteil (302) und der zumindest eine Tiegel-Wandteil (303) an den einander zugewendeten Enden in einer vorbestimmten relativen Position zueinander ausgerichtet positioniert sind.

17. Vorrichtung (200) nach einem der vorhergehenden Ansprüche, **dadurch gekennzeichnet, dass** ein Gehäuse (215) vorgesehen ist, welches Gehäuse (215) eine Aufnahmekammer (216) definiert und der Tiegel (201, 301) samt der Umhüllungseinheit (206) und der Halteeinheit (207) in der Aufnahmekammer (216) aufgenommen ist.

18. Vorrichtung (200) nach einem der vorhergehenden Ansprüche, **dadurch gekennzeichnet, dass** eine Heizvorrichtung (217) vorgesehen ist, welche Heizvorrichtung (217) bevorzugt umfänglich um das Gehäuse (215) herum angeordnet ist und dazu ausgebildet ist, um für den Tiegel (201, 301) Wärmeenergie bereitzustellen.

## Claims

1. A device (200) for growing crystals, comprising
- a crucible (201, 301), which crucible (201, 301) defines an outer lateral surface (203) and moreover delimits an accommodation space (202) with an axial extension between a bottom section (204) and an opening section (205), wherein the accommodation space (202) is designed for growing the crystals,
- an enveloping unit (206), which enveloping unit (206) covers the outer lateral surface (203) at least in sections and is designed for thermally insulating the crucible (201, 301), **characterized in that**
- a holding unit (207) is provided, by means of which holding unit (207) the enveloping unit (206) is held on the crucible (201, 301) in its position relative to the crucible (201, 301),
- the holding unit (207) comprises at least one holding element (208) designed to be oblong and preferably non-rigid, having a first end section (209) and a second end section (210) spaced apart therefrom in its longitudinal extension,
- the at least one holding element (208) surrounds the enveloping unit (206) in a circumferential manner on the side facing away from the crucible (201, 301) and is arranged so as to contact the enveloping unit (206), and
- the first end section (209) and the second end section (210) are coupled to one another so as to be releasable as needed, and a holding force acting on the enveloping unit (206) in the radial direction is applied by the at least one holding element (208).

2. The device (200) according to claim 1, **characterized in that** the at least one holding element (208) is formed by a graphite material.

3. The device (200) according to claim 1 or 2, **characterized in that** the first end section (209) and the second end section (210) of the at least one holding element (208) are knotted together.

4. The device (200) according to claim 1 or 2, **characterized in that** a coupling device (211) is provided for the at least one holding element (208), by means of which coupling device (211) the first end section (209) and the second end section (210) of the at least one holding element (208) are coupled to one another.

5. The device (200) according to one of the preceding claims, **characterized in that** the holding element (208) designed to be oblong and preferably non-rigid is selected from the group of cord, rope, strip, belt, chain.

6. The device (200) according to one of the preceding claims, **characterized in that** multiple holding elements (208) are provided and the holding elements (208) are arranged so as to be spaced apart from one another in the direction of the axial extension of the crucible (201, 301).

7. The device (200) according to one of the preceding claims, **characterized in that** the holding unit (207) comprises at least one guide element (212), which at least one guide element (212) is arranged on the enveloping unit (206) on the side facing away from the crucible (201, 301), and the at least one guide element (212) is configured to guide the at least one holding element (208) in a predefined relative position with respect to the enveloping unit (206).

8. The device (200) according to one of the preceding claims, **characterized in that** the enveloping unit (206) has a first longitudinal edge section (213) and a second longitudinal edge section (214) when observed in the circumferential direction, and the longitudinal edge sections (213, 214) facing one another are arranged so as to overlap in the circumferential direction.

9. The device (200) according to one of the preceding claims, **characterized in that** the enveloping unit (206) protrudes beyond the crucible (201, 301) in the direction of its axial extension on at least one side facing away from the crucible (201, 301).

10. The device (200) according to one of the preceding claims, **characterized in that** the enveloping unit (206) is formed by a graphite felt.

11. The device (200) according to claim 10, **characterized in that** the graphite felt comprises at least one layer of a hard graphite felt.

12. The device (200) according to claim 10 or 11, **characterized in that** the graphite felt comprises at least one layer of a soft graphite felt.

13. The device (200) according to one of claims 10 to 12, **characterized in that** the at least one layer of a hard graphite felt is arranged closer to the crucible (201, 301) than the at least one layer of the soft graphite felt.

14. The device (200) according to one of the preceding claims, **characterized in that** the crucible (201, 301) is formed by a material, which is selected from a group, which comprises metal-based, oxide-based, nitride-based, carbon-based and dense graphite.

15. The device (200) according to one of the preceding claims, **characterized in that** the crucible (301) is designed to have multiple parts and comprises a crucible bottom part (302), at least one crucible wall part (303) and a crucible cover part (304).

16. The device (200) according to claim 15, **characterized in that** a positioning assembly (305) is provided, by means of which positioning assembly (305) at least the crucible bottom part (302) and the at least one crucible wall part (303) are positioned on the ends facing one another oriented in a predefined position relative to one another.

17. The device (200) according to one of the preceding claims, **characterized in that** a housing (215) is provided, which housing (215) defines an accommodation chamber (216), and the crucible (201, 301) along with the enveloping unit (206) and the holding unit (207) is accommodated in the accommodation chamber (216).

18. The device (200) according to one of the preceding claims, **characterized in that** a heating device (217) is provided, which heating device (217) is preferably arranged circumferentially around the housing (215) and is configured to provide thermal energy for the crucible (201, 301).

## Revendications

1. Dispositif (200) pour la croissance de cristaux, comprenant
- un creuset (201, 301), ce creuset (201, 301) définissant une surface d'enveloppe externe (203) et entourant en outre un espace de logement (202) avec une extension axiale entre une portion de fond (204) et une portion d'ouverture (205), dans lequel l'espace de logement (202) est conçu pour la croissance de cristaux,
- une unité d'enveloppe (206), cette unité d'enveloppe (206) recouvrant au moins à certains endroits la surface d'enveloppe externe (203) et étant conçue pour l'isolation thermique du creuset (201, 301),
**caractérisé en ce que**
- une unité de maintien (207) est prévue, cette unité de maintien (207) permettant de maintenir l'unité d'enveloppe (206) dans sa position par rapport au creuset (201, 301) sur le creuset (201, 301),
- l'unité de maintien (207) comprend au moins un élément de maintien (208) allongé, de préférence flexible, avec une première portion d'extrémité (209) et une deuxième portion d'extrémité (210) distante de celle-ci dans son extension longitudinale,
- l'au moins un élément de maintien (208) entoure l'unité d'enveloppe (206) sur le côté opposé au creuset (201, 301), sur sa circonférence et est disposé sur l'unité d'enveloppe (206) de façon à être appuyé contre celle-ci et
- la première portion d'extrémité (209) et la deuxième portion d'extrémité (210) sont couplées entre elles de manière amovible si besoin et l'au moins un élément de maintien (208) exerce une force de maintien dans la direction radiale sur l'unité d'enveloppe (206).

2. Dispositif (200) selon la revendication 1, **caractérisé en ce que** l'au moins un élément de maintien (208) est constitué d'un matériau de type graphite.

3. Dispositif (200) selon la revendication 1 ou 2, **caractérisé en ce que** la première portion d'extrémité (209) et la deuxième portion d'extrémité (210) de l'au moins un élément de maintien (208) sont entremêlées.

4. Dispositif (200) selon la revendication 1 ou 2, **caractérisé en ce qu'**un dispositif de couplage (211) est prévu pour l'au moins un élément de maintien (208), ce dispositif de couplage (211) permettant de coupler entre elles la première portion d'extrémité (209) et la deuxième portion d'extrémité (210) de l'au moins un élément de maintien (208).

5. Dispositif (200) selon l'une des revendications précédentes, **caractérisé en ce que** l'élément de maintien allongé, de préférence flexible (208) est sélectionné dans le groupe constitué d'un cordon, d'un câble, d'une bande, d'une sangle, d'une chaîne.

6. Dispositif (200) selon l'une des revendications précédentes, **caractérisé en ce que** plusieurs éléments de maintien (208) sont prévus et les éléments de maintien (208) sont disposés de manière distante entre eux dans la direction de l'extension axiale du creuset (201, 301).

7. Dispositif (200) selon l'une des revendications précédentes, **caractérisé en ce que** l'unité de maintien (207) comprend au moins un élément de guidage (212), cet au moins un élément de guidage (212) étant disposé sur l'unité d'enveloppe (206) sur le côté opposé au creuset (201, 301) et l'au moins un élément de guiage (212) est conçu pour guider l'au moins un élément de maintien (208) dans une position relative prédéterminée par rapport à l'unité d'enveloppe (206).

8. Dispositif (200) selon l'une des revendications précédentes, **caractérisé en ce que** l'unité d'enveloppe (206) présente, vue dans la direction de la circonférence, une première portion de bord longitudinal (213) et une deuxième portion de bord longitudinal (214) et les portions de bords longitudinaux (213, 214), orientée l'une vers l'autre, sont disposées dans la direction de la circonférence de façon à se chevaucher entre elles.

9. Dispositif (200) selon l'une des revendications précédentes, **caractérisé en ce que** l'unité d'enveloppe (206) dépasse du creuset (201, 301) dans la direction de son extension axiale sur au moins un côté opposé au creuset (201, 301).

10. Dispositif (200) selon l'une des revendications précédentes, **caractérisé en ce que** l'unité d'enveloppe (206) est constituée d'un feutre de graphite.

11. Dispositif (200) selon la revendication 10, **caractérisé en ce que** le feutre de graphite comprend au moins une couche constituée d'un feutre dur de graphite.

12. Dispositif (200) selon la revendication 10 ou 11, **caractérisé en ce que** le feutre de graphite comprend au moins une couche constituée d'un feutre mou de graphite.

13. Dispositif (200) selon l'une des revendications 10 à 12, **caractérisé en ce que** l'au moins une couche en feutre dur de graphite est disposée plus près du creuset (201, 301) que l'au moins une couche de feutre mou de graphite.

14. Dispositif (200) selon l'une des revendications précédentes, **caractérisé en ce que** le creuset (201, 301) est constitué d'un matériau qui est sélectionné dans un groupe comprenant un graphite à base de métal, à base d'oxyde, à base de nitrure, à base de carbone et dense.

15. Dispositif (200) selon l'une des revendications précédentes, **caractérisé en ce que** le creuset (301) est constitué de plusieurs parties et comprend une partie de fond de creuset (302), au moins une partie de paroi de creuset (303) et une partie de couvercle de creuset (304).

16. Dispositif (200) selon la revendication 15, **caractérisé en ce qu'**un dispositif de positionnement (305) est prévu, ce dispositif de positionnement (305) permettant de positionner au moins la partie de fond du creuset (302) et l'au moins une partie de paroi du creuset (303) sur les extrémités orientées les unes vers les autres dans une position relative prédéterminée entre elles.

17. Dispositif (200) selon l'une des revendications précédentes, **caractérisé en ce qu'**un boîtier (215) est prévu, ce boîtier (215) définissant une chambre de logement (216) et le creuset (201, 301), avec l'unité d'enveloppe (206) et l'unité de maintien (207), est logé dans la chambre de logement (216).

18. Dispositif (200) selon l'une des revendications précédentes, **caractérisé en ce qu'**un dispositif de chauffage (217) est prévu, ce dispositif de chauffage (217) étant disposé de préférence autour du boîtier (215) sur sa circonférence et étant conçu pour apporter de l'énergie thermique au creuset (201, 301).
